# EUROPÄISCHE PATENTSCHRIFT

(11) **EP 0 444 493 B1**
(45) Veröffentlichungstag und Bekanntmachung des Hinweises auf die Patenterteilung: **20.11.1996**
(21) Anmeldenummer: 91102244.0
(22) Anmeldetag: 18.02.1991
(51) Int. Cl.: G03F 7/038, G03F 7/016

(54) **Negativ arbeitendes strahlungsempfindliches Gemisch und daraus hergestelltes Aufzeichnungsmaterial**
Negative working radiation sensitive composition and radiation sensitive recording material produced therefrom
Composition radiosensible à effet négatif et matériau d'enregistrement produit à partir de cela

(30) Priorität: 28.02.1990 DE 4006190
(43) Veröffentlichungstag der Anmeldung: 04.09.1991
(73) Patentinhaber: HOECHST AKTIENGESELLSCHAFT, 65926 Frankfurt am Main (DE)
(72) Erfinder: Pawloski, Georg, Dr. Dipl.-Chem., W-6200 Wiesbaden (DE); Dammel, Ralph, Dr. Dipl.-Chem., W-6501 Klein-Winternheim (DE); Röschert, Horst, Dr. Dipl.-Chem., W-6531 Ober-Hilbersheim (DE); Spiess, Walter, Dr. Dipl.-Chem., W-6110 Dieburg (DE); Meyer, Winfried, Dipl.-Ing., W-6230 Frankfurt am Main 80 (DE)

(56) Entgegenhaltungen:
- EP-A- 0 378 068
- DE-A- 3 930 086
- DE-A- 3 930 087

## Beschreibung

Die Erfindung betrifft ein negativ arbeitendes, strahlungsempfindliches Gemisch, das als wesentliche Bestandteile
a) eine bei Bestrahlung eine starke Säure bildende Verbindung,
b) eine Verbindung mit mindestens zwei durch Säure vernetzbaren reaktiven Gruppen und
c) ein in Wasser unlösliches, in wäßrig-alkalischen Lösungen lösliches oder zumindest quellbares Bindemittel
enthält.

Die Erfindung betrifft weiterhin ein daraus hergestelltes strahlungsempfindliches Aufzeichnungsmaterial, das zur Herstellung von Photoresists, elektronischen Bauteilen, Druckplatten oder zum Formteilätzen geeignet ist.

Bei der UV-Lithographie ist die Grenze der Auflösung durch die Wellenlänge der verwendeten Strahlung vorgegeben. Die stetige Verkleinerung der Strukturdimensionen, beispielsweise in der Chip-Herstellung, erfordert daher im Submikronbereich veränderte Lithographietechniken. Wegen ihrer kurzen Wellenlänge werden beispielsweise energiereiches UV-Licht oder Elektronen- und Röntgenstrahlen verwendet. Die Veränderung der Lithographietechniken äußert sich insbesondere aber in einer Veränderung der Ansprüche an das strahlungsempfindliche Gemisch. Eine Zusammenstellung dieser Ansprüche wird beispielsweise im Aufsatz von C.G. Willson "Organic Resist Materials - Theory and Chemistry" (Introduction to Microlithography, Theory, Materials, and Processing, Herausgeber L.F. Thompson, C.G. Willson, M.J. Bowden, ACS Symp. Ser., 219, 87 (1983), American Chemical Society, Washington) gegeben. Es besteht daher ein verstärkter Bedarf an strahlungsempfindlichen Gemischen, die vorzugsweise in einem weiten Spektralbereich empfindlich sind und dementsprechend in der konventionellen UV-Lithographie oder ohne Empfindlichkeitseinbußen in den fortgeschrittenen Technologien, wie z.B. der Mid- oder Deep-UV-, Elektronen- oder Röntgenstrahllithographie, einsetzbar sind.

Negativ arbeitende strahlungsempfindliche Gemische, die Bisazide als Vernetzer und Isoprenderivate als Bindemittel enthalten sind bekannt und wurden in der Vergangenheit zur Herstellung von Photoresisten für Druckplatten, gedruckte Schaltungen und integrierte Schaltkreise verwendet. Ihr Einsatz insbesondere in der Mikrolithographie ist jedoch durch verschiedene technische Nachteile begrenzt: es ist schwierig, defektfreie, hochqualitative Schichten ohne Fehlstellen (pin-holes) herzustellen; der Wärmestand solcher Mischungen ist unzureichend, so daß es bei der Verarbeitung zu Wiedergabeverzerrungen durch thermischen Fluß der Mischungen kommen kann, und schließlich wird ihr Auflösungsvermögen auf Strukturen > 2 µm begrenzt, da sie bei der notwendigen Entwicklung mit organischen Lösungsmitteln auch in den gehärteten Bereichen zu unerwünscht hoher Quellung neigen, was sich wiederum in Strukturverzerrungen oder inhomogenen Entwicklungsprozessen und damit unzureichender Reproduktion der Präzision der Strukturvorgaben einer Maske niederschlägt.

Aus vorstehend genannten Gründen wurden andere negativ arbeitende strahlungsempfindliche Gemische vorgeschlagen, die mit Strahlung kürzerer Wellenlänge, beispielsweise energiereicher UV-, Elektronenoder Röntgenstrahlung bestrahlbar sind, um die Erzeugung feinerer Strukturen als 2 µm zu gestatten.

Ein derartiges Material besteht beispielsweise aus einem Copolymer oder Gemisch aus Glycidylmethacrylat und 2,3-Dichlorpropylmethacrylat (DCOPA). Auch in diesem Material ist die Glastemperatur für viele Anwendungen unzureichend, insbesondere ist aber seine geringe Plasmaätzbeständigkeit zu bemängeln. Darüber hinaus muß auch dieses Material mit wenig umweltfreundlichen, organische Lösemittel enthaltenden Entwicklern verarbeitet werden. Die vorstehend beschriebene geringe Plasmaätzbeständigkeit ist ein Problem, das auch für andere bekannte negativ arbeitende Photoresiste auf aliphatischer Basis Gültigkeit hat.

In der EP-A 0 164 248 wurde daher ein säurehärtbares Gemisch vorgeschlagen, das wässrig-alkalisch entwickelbar ist, durch die Verwendung von Aromaten eine verbesserte Plasmaätzresistenz aufweist und gegenüber nahem UV-Licht (350 - 450 nm) empfindlich ist. Als zur Säureerzeugung geeignete Verbindungen sind dabei insbesondere Sulfonsäureesterderivate des Diazonaphthochinons vorgeschlagen worden, die bei der Belichtung schwach acide Carbonsäuren bilden und daher in vergleichsweise hohen Konzentrationen eingesetzt werden müssen. Solche Mischungen sind aber infolge der schwachen Absorptionen des photolytischen Säurespenders und seines unzureichenden Ausbleichverhaltens sowie ihrer geringen Empfindlichkeit im tiefen UV für Anwendungen in diesem Bereich, wie auch für Elektronen- und Röntgenstrahlung, ungeeignet.

In der US-A 3,692,560 wird die Kombination eines säurehärtbaren Gemischs auf Basis eines säurevernetzbaren Melaminderivats, eines Novolaks und chlorierter Benzophenone als photolytische Säurespender beschrieben. Auch diese Mischungen haben im tiefen UV-Bereich keine ausreichende Empfindlichkeit. Darüber hinaus ist die photolytische Bildung von Halogenwasserstoffsäuren als Vernetzungskatalysator unerwünscht, da diese typischerweise bei den nachfolgenden Dotierungsprozessen mit den Dotierungsmitteln Reaktionen eingehen können. Desweiteren wirken die im gehärteten Resist verbleibenden Halogenwasserstoffsäuren stark korrosiv und können zur Zerstörung des bebilderbaren Materials und der Produktionsgeräte führen.

Das gleiche trifft für die in der EP 0 232 972 erwähnten Abkömmlinge des dort beanspruchten Säuregenerators DDT zu, welches hochtoxisch ist und schon von daher nicht praxisgerecht erscheint. Immerhin kann jedoch mit solchen Verbindungen eine beachtliche Empfindlichkeit im tiefen UV-Bereich (200 - 300 nm) erzielt werden.

Als weitere Verbindungen (a), die als photolytische Säurespender charakterisiert werden können, wurden bisher insbesondere Onium-Salze, wie Diazonium-, Phosphonium-, Sulfonium- und Jodonium-Salze von nicht nukleophilen Säuren, z.B. von HSbF₆, HAsF₆, oder HPF₆ (J.V. Crivello, Polym. Eng. Sci., 23, 953 (1983), Halogenverbindungen (EP-A 0 232 972, DE-A 15 72 089 (= GB-A 1 163 324), DE-A 18 17 540 (= US-A 3,615,455), DE-A 19 49 010 (= US-A 3,686,084), DE-A 23 17 846 (= GB-A 1 381 471 und 1 381 472), US-A 3,912,606), insbesondere Trichlormethyltriazinderivate (DE-A 12 98 414 (= GB-A 1 234 648), 22 43 621 (= GB-A 1 388 492), 23 06 248, 27 18 259 (= US-A 4,189,323), 33 33 450 (= ZA 84/7165) und 33 37 024 (= US-A 4,619,998 und 4,696,888) sowie US-A 3,515,552, 3,536,489 und 3,615,630) oder Trichlormethyloxadiazolderivate (DE-A 28 51 472 (= US-A 4,212,970 und 4,232,106), 29 49 396 (= US-A 4,279,982), 30 21 590 (= US-A 4,371,607), 30 21 599 (= US-A 4,371,606) und DE-A 33 33 450), o-Chinondiazidsulfochloride oder Organometall-Organohalogen-Kombinationen empfohlen.

Diese Verbindungen wurden teilweise in negativ arbeitenden, teilweise in positiv arbeitenden strahlungsempfindlichen Gemischen empfohlen. Die Verwendung derartiger photolytischer Säurespender bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, was in einer Begrenzung der Auswahl der Belackungslösemittel resultiert. Darüber hinaus werden bei Verwendung der Oniumsalze z.T. unerwünschte Fremdatome eingeführt, die insbesondere in der Mikrolithographie zu Prozeßstörungen führen können. Ferner bilden auch sie bei der Photolyse sehr stark korrodierend wirkende Bronstedt-Säuren, die den Einsatz von diese enthaltenden strahlungsempfindlichen Gemischen auf empfindlichen Substraten unbefriedigend machen. Wie bereits früher erwähnt, bilden auch die Halogenverbindungen sowie die Chinondiazidsulfonsäurechloride stark korrosiv wirkende Halogenwasserstoffsäuren. Ferner besitzen derartige Verbindungen auf gewissen Substraten nur eine begrenzte Haltbarkeit, die entsprechend den Lehren der DE-A 36 21 376 (= US-A 4,840,867) in der Vergangenheit dadurch verbessert wurde, daß zwischen Substrat und strahlungsempfindlicher, Verbindungen des Typs (a) enthaltender Schicht eine Zwischenschicht eingezogen wurde, was allerdings zu einer unerwünschten Zunahme von Defekten und einer Verminderung der Prozeßreproduzierbarkeit führt.

Neuere Arbeiten von F.M. Houlihan et al., SPIE 920, 67 (1988) haben anhand positiv arbeitender Systeme gezeigt, daß neben den oben genannten Säurespendern auch Nitrobenzyltosylate, die bei Belichtung wenig bewegliche Sulfonsäuren bilden, in gewissen säurelabilen Resistformulierungen verwendbar sind. Es kann aus diesen Ergebnissen abgeleitet werden, daß solche Verbindungen auch für photohärtbare Systeme Verwendung finden können. Die dabei erzielten Empfindlichkeiten und die thermische Stabilität der Photoresiste erwiesen sich jedoch als unzureichend.

Trotz der zahlreichen Erfindungen und Verbesserungen auf diesem Gebiet ist derzeit kein Material bekannt, das wäßrig-alkalisch entwickelbare, thermisch stabile strahlungsempfindliche negativ arbeitende Gemische vorschlägt, in denen hohe Empfindlichkeit im tiefen UV-Bereich mittels wenig korrodierender photolytisch erzeugter Säuren verknüpft ist mit hoher Auflösung.

Wegen der aufgeführten Nachteile besteht daher ein Bedarf an weiteren photolytisch wirkenden Säurespendern, die als Bestandteile von strahlungsempfindlichen Gemischen die oben beschriebenen Nachteile nicht aufweisen und die somit eine ausreichende Reaktivität und Säurestärke besitzen, um Verbindungen des Typs (b) auch bei kurzen Belichtungszeiten zur Vernetzung zu bringen.

Aufgabe der Erfindung war es daher, ein strahlungsempfindliches Gemisch auf Basis von säurebildenden in Kombination mit säurevernetzbaren Verbindungen vorzuschlagen, wobei die photolytisch eine Säure bildende Verbindung (a) möglichst stabil auf allen bekannten Substraten sein sollte und als Photoprodukt eine nicht korrosiv wirkende Säure generiert.

Erfindungsgemäß wird ein strahlungsempfindliches Gemisch vorgeschlagen, das als wesentliche Bestandteile
a) eine unter Einwirkung aktinischer Strahlung eine starke Säure bildende Verbindung,
b) eine Verbindung mit mindestens zwei durch Säure vernetzbaren reaktiven Gruppen und
c) ein in Wasser unlösliches, in wäßrig-alkalischen Lösungen lösliches oder zumindest quellbares Bindemittel
enthält.

Das erfindungsgemäße Gemisch ist dadurch gekennzeichnet, daß die bei Bestrahlung eine starke Säure bildende Verbindung (a) eine Verbindung der allgemeinen Formel I 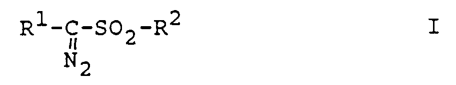 ist, worin R₁ einen der Reste

R²-SO₂- oder R³-C(O)-

und R² und R³ voneinander unabhängig einen ggf. substituierten Alkyl-, Cycloalkyl-, Aryl- oder Heteroarylrest bedeuten. Bevorzugt sind (C₁-C₁₆)Alkyl, insbesondere (C₁-C₆)Alkyl, (C₅-C₁₂)Alkyl, (C₅-C₁₂)Cycloalkyl, insbesondere C₆-Cycloalkyl, (C₆-C₁₂)Aryl und ein ein- oder zweikerniger, jeweils fünf- oder sechsgliedriger Heteroalkylrest mit O, S oder N als Heteroatome.

Diese Verbindungen sind demnach den Gruppen der α,α-Bis-sulfonyldiazomethane (R¹ = R²-SO₂) oder der α,α-Carbonylsulfonyldiazomethane [R¹ = R³-C(O)] zuzuordnen. Die Verwendung dieser Verbindungen in hochempfindlichen positiv arbeitenden Gemischen ist in den nicht vorveröffentlichten deutschen Patentanmeldungen 39 30 086.2 und 39 30 087.2 beschrieben.

Erfindungsgemäß wird darüber hinaus ein strahlungsempfindliches Aufzeichnungsmaterial vorgeschlagen, das auf einem Träger als strahlungsempfindliche Schicht das oben beschriebene Gemisch enthält.

Das erfindungsgemäße strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage strukturgenau wiederzugeben. Durch die Belichtung werden keine korrodierenden Photolyseprodukte gebildet, so daß das Gemisch auch auf empfindlichen Substratmaterialien Verwendung finden kann.

Für die Herstellung des strahlungsempfindlichen Gemischs können Verbindungen der allgemeinen Formel I verwendet werden, in denen R² und R³ je einen voneinander unabhängigen, ggf. substituierten Alkyl-, Cycloalkyl-, einen ggf. substituierten Arylrest oder einen ggf. substituierten Heteroarylrest darstellen.

Beispiele geeigneter Substituenten R² und R³ in Verbindungen der allgemeinen Formel I sind:

Methyl-, Ethyl-, Propyl-, Butyl-, Pentyl-, Hexyl-, Cyclohexyl-, Nonyl-, Decyl- oder Undecylgruppen, sowie deren Stellungsisomere, Benzol und Naphthalin sowie deren Derivate, in denen ein oder mehrere Wasserstoffatome beispielsweise durch Alkyl-, Alkoxy-, Alkoxyalkyl-, Aryl-, Aryloxy-, Arylalkoxy-, Halogen-, Cyano-, Nitro-, Carbonyl-, Carboxyl- oder ähnliche Reste substituiert sind. Besonders bevorzugte Substituenten sind Alkyl, Alkoxy, Alkoxyalkyl, Halogene, insbesondere Fluor, Chlor oder Brom, sowie Cyano, wobei Alkyl- bzw. Alkoxyalkylreste insbesondere 1 bis 4 C-Atome enthalten. Sofern eine Mehrfachsubstitution der aromatischen Reste vorliegt, kommen als Substituenten vorwiegend (C₁-C₄)Alkyl und die genannten Halogene Chlor und Brom in Frage. Insbesondere handelt es sich dann hierbei um zweifach substituierte Reste R. Sofern allerdings Fluor als Substituent des Restes R vorliegt, können auch mehr als zwei Fluoratome als Substituenten des Restes R vorkommen; letztere sind aber nicht bevorzugt. Ist R Heteroaryl, so umfaßt dieser vorwiegend ein Heteroatom, auch dann, wenn R ein zweikerniger Rest bedeutet. Sofern N als Heteroatom gewählt ist, kann dieser maximal zweimal pro Kern auftreten.

Unter den Verbindungen der allgemeinen Formel I sind solche bevorzugt, in denen R² oder R³ voneinander unabhängig einen Alkylrest mit 1 bis 6 Kohlenstoffatomen oder einen ggf. substituierten Arylrest aufweisen, und mindestens einer der Reste R² oder R³ einen ggf. substituierten Arylrest darstellt, wobei ein- oder zweikernige (C₆-C₁₂)Arylreste besonders bevorzugt sind.

Besonders bevorzugt sind Verbindungen der allgemeinen Formel I, in denen R² und R³ mindestens einen voneinander unabhängigen ggf. substituierten Arylrest darstellen. Als Beispiele für bevorzugte Verbindungen seien genannt:
Methylsulfonyl-benzoyl-diazomethan
Ethylsulfonyl-benzoyl-diazomethan
Methylsulfonyl-4-brom-benzoyl-diazomethan
Ethylsulfonyl-4-brom-benzoyl-diazomethan
Phenylsulfonyl-benzoyl-diazomethan
Phenylsulfonyl-m-toluoyl-diazomethan
Phenylsulfonyl-p-toluoyl-diazomethan
Phenylsulfonyl-3-methoxy-benzoyl-diazomethan
Phenylsulfonyl-4-methoxy-benzoyl-diazomethan
Phenylsulfonyl-3-chlor-benzoyl-diazomethan
Phenylsulfonyl-4-chlor-benzoyl-diazomethan
Phenylsulfonyl-2-brom-benzoyl-diazomethan
Phenylsulfonyl-3-brom-benzoyl-diazomethan
Phenylsulfonyl-4-brom-benzoyl-diazomethan
Phenylsulfonyl-4-cyano-benzoyl-diazomethan
Phenylsulfonyl-1-naphthoyl-diazomethan
Phenylsulfonyl-2-naphthoyl-diazomethan
P-Tolylsulfonyl-benzoyl-diazomethan
P-Tolylsulfonyl-m-toluoyl-diazomethan
P-Tolylsulfonyl-p-toluoyl-diazomethan
P-Tolylsulfonyl-3-methoxy-benzoyl-diazomethan
P-Tolylsulfonyl-4-methoxy-benzoyl-diazomethan
P-Tolylsulfonyl-3-chlor-benzoyl-diazomethan
P-Tolylsulfonyl-4-chlor-benzoyl-diazomethan
P-Tolylsulfonyl-2-brom-benzoyl-diazomethan
P-Tolylsulfonyl-3-brom-benzoyl-diazomethan
P-Tolylsulfonyl-4-brom-benzoyl-diazomethan
P-Tolylsulfonyl-4-cyano-benzoyl-diazomethan
P-Tolylsulfonyl-1-naphthoyl-diazomethan
P-Tolylsulfonyl-2-naphthoyl-diazomethan
Bis-(methylsulfonyl)-diazomethan
Bis-(ethylsulfonyl)-diazomethan
Bis-(propylsulfonyl)-diazomethan
Bis-(1-methylpropylsulfonyl)-diazomethan
Bis-(2-methylpropylsulfonyl)-diazomethan
Bis-(butylsulfonyl)-diazomethan
Bis-(1-methylbutylsulfonyl)-diazomethan
Bis-(2-methylbutylsulfonyl)-diazomethan
Bis-(3-methylbutylsulfonyl)-diazomethan
Bis-(allylsulfonyl)-diazomethan
Bis-(heptylsulfonyl)-diazomethan
Bis-(octylsulfonyl)-diazomethan
Bis-(nonylsulfonyl)-diazomethan
Bis-(decylsulfonyl)-diazomethan
Bis-(dodecylsulfonyl)-diazomethan
Bis-(trifluormethylsulfonyl)-diazomethan
Bis-(hexadecylsulfonyl)-diazomethan
Bis-(cyclohexylsulfonyl)-diazomethan
Bis-(2-oxapentylsulfonyl)-diazomethan
Bis-(benzylsulfonyl)-diazomethan
Bis-(2-chlorbenzylsulfonyl)-diazomethan
Bis-(4-chlorbenzylsulfonyl)-diazomethan
Bis-(4-methoxysulfonyl)-diazomethan
Bis-(phenylsulfonyl)-diazomethan
Bis-(2-methylphenylsulfonyl)-diazomethan
Bis-(3-methylphenylsulfonyl)-diazomethan
Bis-(4-methylphenylsulfonyl)-diazomethan
Bis-(4-ethylphenylsulfonyl)-diazomethan
Bis-(2,4-dimethylphenylsulfonyl)-diazomethan
Bis-(2,5-dimethylphenylsulfonyl)-diazomethan
Bis-(3,4-dimethylphenylsulfonyl)-diazomethan
Bis-(4-t-butylphenylsulfonyl)-diazomethan
Bis-(2-methoxyphenylsulfonyl)-diazomethan
Bis-(3-methoxyphenylsulfonyl)-diazomethan
Bis-(4-methoxyphenylsulfonyl)-diazomethan
Bis-(2-chlorphenylsulfonyl)-diazomethan
Bis-(3-chlorphenylsulfonyl)-diazomethan
Bis-(4-chlorphenylsulfonyl)-diazomethan
Bis-(2,5-dichlorophenylsulfonyl)-diazomethan
Bis-(2,6-dichlorophenylsulfonyl)-diazomethan
Bis-(3,4-dichlorophenylsulfonyl)-diazomethan
Bis-(2-bromphenylsulfonyl)-diazomethan
Bis-(3-bromphenylsulfonyl)-diazomethan
Bis-(4-bromphenylsulfonyl)-diazomethan
Bis-(4-fluorphenylsulfonyl)-diazomethan
Bis-(2,4-difluorphenylsulfonyl)-diazomethan
Bis-(pentafluorphenylsulfonyl)-diazomethan
Bis-(4-nitrophenylsulfonyl)-diazomethan
Bis-(4-acetamidophenylsulfonyl)-diazomethan
Bis-(4-acetoxyphenylsulfonyl)-diazomethan
Bis-(2-naphthalinsulfonyl)-diazomethan
Bis-(furfurylsulfonyl)-diazomethan
Bis-(imidazolylsulfonyl)-diazomethan
Bis-(2-methylimidazolylsulfonyl)-diazomethan
Bis-(benzimidazol-2-sulfonyl)-diazomethan
Bis-(benzoxazol-2-sulfonyl)-diazomethan
Bis-(benzothiazol-2-sulfonyl)-diazomethan

Diese Verbindungen sind deshalb besonders geeignet, weil sie einerseits eine hohe Photolysereaktivität aufweisen, andererseits aber eine ausreichende thermische Stabilität besitzen.

Die oben aufgeführten Verbindungen haben hohe Absorptionsmaxima im Bereich zwischen 220 bis 270 nm und sind daher für eine Bestrahlung mit energiereicher UV-Strahlung sehr gut geeignet. Darüber hinaus weisen sie aber auch geringere Absorptionen im Bereich zwischen 350 - 450 nm auf und sind daher gleichfalls zur Belichtung mit nahem UV-Licht geeignet.

Von den obengenannten Verbindungen der allgemeinen Formel I, in denen R² und R³ einen substituierten Arylrest darstellen, sind folgende Verbindungen besonders bevorzugt:
Phenylsulfonyl-benzoyl-diazomethan
Phenylsulfonyl-p-toluoyl-diazomethan
Phenylsulfonyl-4-methoxy-benzoyl-diazomethan
Phenylsulfonyl-3-chlor-benzoyl-diazomethan
Phenylsulfonyl-4-chlor-benzoyl-diazomethan
Phenylsulfonyl-3-brom-benzoyl-diazomethan
Phenylsulfonyl-4-brom-benzoyl-diazomethan
Phenylsulfonyl-4-cyano-benzoyl-diazomethan
Phenylsulfonyl-1-naphthoyl-diazomethan
Phenylsulfonyl-2-naphthoyl-diazomethan
P-Tolylsulfonyl-benzoyl-diazomethan
P-Tolylsulfonyl-p-toluoyl-diazomethan
P-Tolylsulfonyl-4-methoxy-benzoyl-diazomethan
P-Tolylsulfonyl-3-chlor-benzoyl-diazomethan
P-Tolylsulfonyl-4-chlor-benzoyl-diazomethan
P-Tolylsulfonyl-3-brom-benzoyl-diazomethan
P-Tolylsulfonyl-4-brom-benzoyl-diazomethan
P-Tolylsulfonyl-4-cyano-benzoyl-diazomethan
P-Tolylsulfonyl-1-naphthoyl-diazomethan
P-Tolylsulfonyl-2-naphthoyl-diazomethan
Bis-(2-methylphenylsulfonyl)-diazomethan
Bis-(3-methylphenylsulfonyl)-diazomethan
Bis-(4-methylphenylsulfonyl)-diazomethan
Bis-(4-ethylphenylsulfonyl)-diazomethan
Bis-(2,4-dimethylphenylsulfonyl)-diazomethan
Bis-(3,4-dimethylphenylsulfonyl)-diazomethan
Bis-(4-t-butylphenylsulfonyl)-diazomethan
Bis-(4-methoxyphenylsulfonyl)-diazomethan
Bis-(2-chlorphenylsulfonyl)-diazomethan
Bis-(3-chlorphenylsulfonyl)-diazomethan
Bis-(4-chlorphenylsulfonyl)-diazomethan
Bis-(2,5-dichlorophenylsulfonyl)-diazomethan
Bis-(2,6-dichlorophenylsulfonyl)-diazomethan
Bis-(3,4-dichlorophenylsulfonyl)-diazomethan
Bis-(3-bromphenylsulfonyl)-diazomethan
Bis-(4-bromphenylsulfonyl)-diazomethan
Bis-(4-fluorphenylsulfonyl)-diazomethan
Bis-(2,4-difluorphenylsulfonyl)-diazomethan
Bis-(4-nitrophenylsulfonyl)-diazomethan
Bis-(4-acetoxyphenylsulfonyl)-diazomethan

Die Herstellung der erfindungsgemäß eingesetzten Verbindungen ist an sich bekannt. α-Carbonyl-α-sulfonyldiazomethanderivate können beispielsweise entsprechend den Vorschriften von W. Illger, A. Liedgehegener und M. Regitz, Ann., 760, 1 (1972) synthetisiert werden. Eine Zusammenfassung ihrer Herstellung und Eigenschaften wurde von M. Regitz und G. Maas in dem Buch "Diazo Compounds, Properties and Synthesis", Academic Press, Orlando, 1986 gegeben.

Die Herstellung der erfindungsgemäß eingesetzten α,α-Bis-sulfonyl-diazomethanderivate ist an sich ebenfalls bekannt. Ihre Herstellung wurde beispielsweise von F. Klages et al., Chem. Ber., 97, 735 (1964) beschrieben.

Darüber hinaus wurde die Verwendung der Verbindungen der allgemeinen Formel I als Lösungsinhibitoren für positiv arbeitende Materialien, insbesondere für Druckplatten, in der Vergangenheit von A. Poot et al., J. Photogr. Sci., 19, 88 (1971), untersucht; ihre praktische Eignung in Photoresistformulierungen wurde aber wegen unzureichender Lichtempfindlichkeit ausgeschlossen.

Es war daher besonders überraschend, daß die erfindungsgemäß eingesetzten Verbindungen der allgemeinen Formel I bei ihrer Photolyse ausreichende Mengen von ausreichend starken Säuren bilden, die die Herstellung des erfindungsgemäßen, hochempfindlichen negativ arbeitenden strahlungsempfindlichen Gemischs erlauben. Wenngleich keine genauen Vorstellungen über das Ausmaß und die Art der gebildeten Säuren bestehen, so ist doch davon auszugehen, daß sich insbesondere Sulfon- oder Sulfinsäuren durch die Photolyse bilden.

Gegenüber den bisher verwendeten photolytisch erzeugten Säuren, wie beispielsweise Chlorwasserstoffsäure, zeigen diese Säuren infolge ihres hohen Molekukargewichts eine viel geringere Diffusionsneigung bzw. Beweglichkeit im erfindungsgemäßen strahlungsempfindlichen Gemisch, so daß es einerseits überraschend war, daß eine höchsten Ansprüchen genügende Bilddifferenzierung erreicht werden konnte, und andererseits aber umso überraschender, daß der Kontrast und damit das Härtungsvermögen des strahlungsempfindlichen Gemischs bei vergleichbarer Empfindlichkeit noch gesteigert wurde. Weiterhin war es überraschend, daß die Verbindungen der allgemeinen Formel I auch durch energiereiche, kurzwellige Strahlung aktivierbar sind, und damit beispielsweise die Herstellung eines hochempfindlichen Photoresists für energiereiche UV2-Strahlung (248 nm) möglich ist. Insbesondere war es aber unerwartet, daß sogar noch im Bereich der klassischen optischen Lithographie (436 nm) eine ausreichende spektrale Ansprechbarkeit vorhanden ist.

Als aktinische Strahlung soll in diesem Zusammenhang jede Strahlung verstanden werden, deren Energie mindestens der des kurzwelligen sichtbaren Lichts entspricht. Geeignet ist dabei insbesondere UV-Strahlung im Bereich von 190 bis 450 nm, bevorzugt von 200 bis 400 nm, besonders bevorzugt von 200 bis 300 nm, aber auch Elektronen- oder Röntgenstrahlung.

Die Herstellung der erfindungsgemäß eingesetzten, z. T. neuen α-Carbonyl-α-sulfonyl-diazomethane wird anhand des bevorzugten Phenylsulfonyl-4-brombenzoyl-diazomethans verdeutlicht (GT = Gewichtsteile):

27,8 GT 4-Bromphenacylbromid und 16.4 GT Natriumbenzolsulfinat werden in 250 GT Ethanol suspendiert und 5 Stunden zum Rückfluß erhitzt. Die noch warme Lösung wird filtriert. Nach der Abkühlung wird der gebildete Niederschlag abgesaugt und aus Ethanol umkristallisiert. Man erhält 25,5 GT fast farbloser Kristalle, die sich als analysenreines Phenylsulfonyl-(4-brom-benzoyl)-methan erweisen.

10 GT des vorstehend erhaltenen Produkts werden zusammen mit 4.8 GT Tosylazid in 90 GT Acetonitril gelöst und auf 0°C gekühlt. Zu dieser Mischung werden 2,5 GT Triethylamin derart zugetropft, daß die Temperatur unterhalb von 10°C bleibt. Die Mischung wird 8 Stunden bei Raumtemperatur nachgerührt und anschließend vom Lösemittel befreit. Der Rückstand wird in Methylenchlorid aufgenommen und zweimal mit 100 GT 5% wässriger Natriumhydroxyd-Lösung extrahiert, neutral gewaschen und getrocknet. Nach Abdampfen des Lösemittels verbleibt ein Feststoff, der aus Essigester umkristallisiert wird. Man erhält 7,5 GT blaßgelber Kristalle mit einem Zersetzungspunkt von 122 °C, die sich als analysenreines Phenylsulfonyl-(4-brombenzoyl)-diazomethan erweisen.

Die Analyse dieser Verbindung ergab folgende Werte:

| | | | | | |
|---|---|---|---|---|---|
| ber.: | C 46,02%, | H 2,47%, | N 7,67%, | S 8,76%, | Br 21,91% |
| gef.: | C 47,1 %, | H 2,3 %, | N 7,5 %, | S 8,4 %, | Br 22,7 % |

¹H-NMR (CDCl₃): 7.4 - 8.2 ppm (m, 9 H).
λₘₐₓ(CHCl₃)= 242 nm.

Die Herstellung der erfindungsgemäß eingesetzten z. T. neuen a,a-Bis-arylsulfonyl-diazomethane wird anhand des bevorzugten Bis-(4-t-butylphenylsulfonyl)-diazomethans verdeutlicht (GT = Gewichtsteile):

37,3 GT 4-t-Butylthiophenol werden in 100 GT Natriumhydroxid versetzt und bis zur Bildung einer klaren Lösung bei Raumtemperatur gerührt. Zu der Thiophenollösung werden 18,2 GT Dichlormethan zugefügt. Das Gemisch wird 8 Stunden zum Rückfluß erhitzt. Das entstandene Formaldehyd-bis-(4-t-butylphenylmercaptal) wird in Ether aufgenommen und mit 2 x 200 ml Wasser gewaschen. Anschließend wird über Magnesiumsulfat getrocknet und der Ether abgezogen. Es verbleiben 36 GT eines farblosen öls.

20 GT dieses öls werden in 40 ml Eisessig gelöst und in eine auf 90 °C vorgewärmte Mischung aus 200 GT Eisessig und 60 GT Wasserstoffperoxid eingetropft, wobei die Tropfgeschwindigkeit so geregelt wird, daß die Temperatur unterhalb 100 °C bleibt. Nach Beendigung der anfangs stark exothermen Reaktion wird weitere 2 Stunden auf 100 °C erwärmt, abgekühlt und in Wasser gegossen. Dabei fallen 16 GT von Bis-(4-t-butylphenylsulfonyl)-methan an. Das Produkt wird aus Ethanol umkristallisiert und fällt mit einem Schmelzpunkt von 150 bis 152 °C an.

10 GT des vorstehend erhaltenen Produkts werden zusammen mit 4,8 GT Tosylazid in 90 GT Acetonitril gelöst und auf 0°C gekühlt. Zu dieser Mischung werden 2,5 GT Triethylamin derart zugetropft, daß die Temperatur unterhalb von 10°C bleibt. Die Mischung wird 4 Stunden bei Raumtemperatur nachgerührt und anschließend vom Lösemittel befreit. Der Rückstand wird in Methylenchlorid aufgenommen und zweimal mit 100 GT 5% wässriger Natriumhydroxyd-Lösung extrahiert, neutral gewaschen und getrocknet. Nach Abdampfen des Lösemittels verbleibt ein Öl, das über eine Kieselgelsäule mit Methylenchlorid als Lösemittel filtriert wird. Erneutes Einengen der Lösung ergibt einen Feststoff mit einem Zersetzungspunkt von 153 bis 155 °C, der sich als analysenreines Bis-4-t-butylphenylsulfonyl-diazomethan erweist.

Die Analyse dieser Verbindung ergab folgende Werte:

| | | | | |
|---|---|---|---|---|
| ber.: | C 58,04% | H 6,03% | N 6,45% | S 14,75% |
| gef.: | C 57,9 % | H 6,1 % | N 6,5 % | S 14,4 % |

¹H-NMR (CDCl₃): 1.4 ppm (s, 18 H), 7,4 bis 8,2 ppm (q, 8 H)
λₘₐₓ(CHCl₃)= 238, 248 nm.

Auf analoge Weise lassen sich die anderen, oben genannten Verbindungen der allgemeinen Formel I herstellen.

Die im erfindungsgemäßen strahlungsempfindlichen Gemisch enthaltenen photolytischen Säurespender können allein oder in Kombination mit anderen Säurespendern der genannten Klasse Verwendung finden. Es sind aber auch Kombinationen mit anderen photolytischen Säurespendern möglich, wie beispielsweise mit Onium-Salzen, wie Diazonium-, Phosphonium-, Sulfonium- und Jodonium-Salzen von nicht nukleophilen Säuren, z.B. von HSbf₆, HAsF₆, oder HPF₆ (J.V. Crivello, Polym. Eng. Sci., 23, 953 (1983), Halogenverbindungen (EP-A 0 232 972, DE-A 15 72 89, DE-A 18 17 540, DE-A 19 49 010, US-A 3,912,606, DE-A 23 17 846), insbesondere Trichlormethyltriazinderivaten (US-A 3,515,552, US-A 3,536,489, US-A 3,615,630, US-A 3,779,778, DE-A 27 18 259, DE-A 33 37 024, DE-A 33 33 450, DE-A 23 06 248, DE-A 22 43 621, DE-A 12 98 414) oder Trichlormethyloxadiazolderivaten (DE-A 30 21 590, DE-A 30 21 599, DE-A 28 51 472, DE-A 29 49 396, DE-A 33 33 450, EP-A 135 348), o-Chinondiazidsulfochloriden oder Organometall-Organohalogen-Kombinationen. Derartige Kombinationen sind aber insgesamt nicht bevorzugt, da in solchen strahlungsempfindlichen Gemischen die eingangs erwähnten Nachteile wieder auftreten.

Der Gehalt an Säurespendern der allgemeinen Formel I im erfindungsgemäßen Gemisch liegt im allgemeinen zwischen 0.5 bis 25 Gew.-%, bevorzugt bei 1 bis 10 Gew.-%, jeweils bezogen auf das Gesamtgewicht der Schicht.

Als säurevernetzbares Material b) kommen prinzipiell die in der GB 2,082,339 offenbarten Resole, alkoxymethyl- oder glycidylsubstituierte Aromaten (EP-A 0 212 482) oder monomer und oligomere Melamin- bzw. Harnstoff-Formaldehyd-Kondensate (EP-A 0 133 216, DE-A 36 34 371, DE 37 11 264) in Betracht. Beispiele für den ersten Typ sind insbesondere die kommerziell erhältlichen Resolprodukte Bakelite R 5363, Bakelite R 17620, Bakelite R 10282 und Kelrez 40-152 (Bakelite und Kelrez sind Markennamen). Derartige Resolderivate sind jedoch insgesamt nicht bevorzugt, da sie im tiefen UV-Bereich verhältnismäßig hohe Absorptionen aufweisen und damit zu einer Beeinträchtigung der Bildwiedergabe führen.

Besser geeignet sind die aus der EP-A 0 212 482 bekannten Vernetzer der allgemeinen Formel II

(R⁴O-CHR⁶)ₙ-A-(CHR⁶-OR⁵)ₘ (II)

in der
- A: -B- oder -B-Y-B- ist und
- B: einen ggf. substituierten einkernigen aromatischen Kohlenwasserstoff oder eine Sauerstoff oder Schwefel enthaltende heterocyclische aromatische Verbindung darstellt,
- Y: eine Einfachbindung, (C₁-C₄)Alkylen oder (C₁-C₄)Alkylendioxy, deren Ketten durch Sauerstoffatome unterbrochen sein können, -O-, -S-, -SO₂-, -CO-,-CO₂-, -O-CO₂-, -CONH- oder Phenylendioxy bedeutet,
- R⁴ und R⁵: Wasserstoff, (C₁-C₆)Alkyl, C₅- oder C₆-Cycloalkyl, ggf. substituiertes (C₆-C₁₂)Aryl, (C₆-C₁₂)Aralkyl oder Acyl ist,
- R⁶: Wasserstoff, (C₁-C₄)-Alkyl oder ggf. substituiertes Phenyl,
- n: eine ganze Zahl von 1 bis 3 und
- m: eine ganze Zahl von 0 bis 3, wobei n+m mindestens 2 ist, bedeuten.

Typisch verwendbare Verbindungen sind demnach mehrfach hydroxymethyl-, acetoxymethyl- und methoxymethyl-substituierte Aromaten und Heterocyclen.

Weitere bevorzugte Vernetzer sind Melamin/Formaldehyd-Derivate, die beispielsweise mindestens zwei freie N-Methylolgruppen, oder alkylsubstituierte bzw. acylsubstitierte Methylolgruppen aufweisen. Insbesondere die N-Methoxyalkylderivate sind zum Einsatz in dem erfindungsgemäßen strahlungsempfindlichen Gemisch geeignet.

Die oben bezeichneten Vernetzungsmittel sind in Lage, bei erhöhten Temperaturen unter dem Einfluß der photolytisch erzeugten Säure die nachstehend beschriebenen Polymeren zu vernetzen; sie sind dadurch gekennzeichnet, daß sie unter den vorstehend beschriebenen Bedingungen ein Carboniumkation bilden können.

Der Gehalt an säurevernetzbarem Material b) in dem erfindungsgemäßen strahlungsempfindlichen Gemisch sollte bei 1 bis 50 Gew.-%, vorzugsweise bei 5 bis 25 Gew.-%, jeweils bezogen auf das Gesamtgewicht der Schicht, liegen.

Das erfindungsgemäße strahlungsempfindliche Gemisch enthält ferner mindestens ein polymeres, in Wasser unlösliches, in wäßrigen alkalischen Lösungen aber lösliches, zumindest aber quellbares Bindemittel c). Das Bindemittel zeichnet sich im besonderen dadurch aus, daß es die Bestandteile des erfindungsgemäßen strahlungsempfindlichen Gemisches gut löst und insbesondere im Wellenlängenbereich von 190 bis 300 nm eine möglichst geringe Eigenabsorption, d.h. eine hohe Transparenz, aufweist. Hierunter fallen insbesondere nicht diejenigen Bindemittel auf der Basis von Novolak-Kondensationsharzen, die in der Regel in Kombination von Naphthochinondiaziden als photoaktive Komponenten eingesetzt worden sind. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption in dem für die Belichtung gewünschten Wellenlängenbereich unerwünscht hoch.

Die genannten Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des p-Hydroxystyrols sowie seiner Alkylderivate, z.B. des 3-Methylhydroxystyrols, sowie Homo- oder Copolymere anderer Polyvinylphenole, z. B. des 3-Hydroxystyrols oder die Ester oder Amide von (Meth)-acrylsäure mit phenolische Gruppen aufweisenden Aromaten. Als Comonomere im Copolymeren können polymerisierbare Verbindungen wie Styrol, Methylmethacrylat, Methylacrylat oder ähnliche eingesetzt werden.

Gemische mit erhöhter Plasmabeständigkeit werden dann erhalten, wenn zur Herstellung von Copolymeren des obigen Typs Silizium enthaltende Vinylmonomere, z. B. Vinyltrimethylsilan, verwendet werden. Die Transparenz dieser Bindemittel ist im interessierenden Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im beschriebenen Wellenlängenbereich. Als Comonomere werden auch hier bevorzugt Styrol, substituierte Styrole, Vinylether, Vinylester, Vinylsilylverbindungen oder (Meth)-acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierunter zählen beispielsweise Maleinsäureanhydrid, Maleinsäurehalbester oder dergleichen.

Die genannten Bindemittel können in Mischungen auftreten, sofern sie mischbar sind und die optischen Qualitäten des strahlungsempfindlichen Gemisches nicht verschlechtern. Bevorzugt sind jedoch Bindemittel, enthaltend einen Typus der oben genannten Arten.

Die Menge des Bindemittels beträgt im allgemeinen 50 bis 96 Gew.-%, insbesondere 60 bis 94 Gew.-%, bezogen auf das Gesamtgewicht der strahlungsempfindlichen Mischung.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z. B. Ethylcellulose, zur Verbesserung spezieller Erfordernisse, wie Flexibilität, Haftung und Glanz, zugesetzt werden.

Vorzugsweise wird das erfindungsgemäße strahlungsempfindliche Gemisch in Lösemitteln [z. B. Ethylenglykol, Glykolether, Glykolmonomethylether, Glykoldimethylether, Glykolmonoethylether oder Propylenglykolmonoalkylether, insbesondere Propylenglykolmethylether, aliphatische Ester (z. B. Ethylacetat, Hydroxyethylacetat, Alkoxyethylacetat, n-Butylacetat, Propylenglykolmonoalkyletheracetate, insbesondere Propylenglykolmethyletheracetat oder Amylacetat), Ether (z. B. Dioxan), Ketone (z. B. Methylethylketon, Methylisobutylketon, Cyclopentanon und Cyclohexanon), Dimethylformamid, Dimethylacetamid, Hexamethylphosphorsäureamid, N-Methyl-pyrrolidon, Butyrolacton, Tetrahydrofuran und Mischungen derselben] gelöst. Besonders bevorzugt werden Glykolether, aliphatische Ester sowie Ketone.

Letztendlich hängt die Wahl der Lösemittel von dem angewandten Beschichtungsverfahren, der gewünschten Schichtstärke und den Trocknungsbedingungen ab. Ebenso müssen die Lösemittel chemisch neutral sein, d. h. sie dürfen nicht mit den übrigen Schichtkomponenten irreversibel reagieren.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, das im wesentlichen aus einem Substrat und dem darauf aufgetragenen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die ggf. auch dotiert sein können, einschließlich aller anderen in der Halbleitertechnologie üblichen Substrate, wie beispielsweise Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien, beispielsweise aus Aluminium, Kupfer, Zink, Bimetall- und Trimetallfolien, aber auch elektrisch nicht leitende Folien, die mit Metallen bedampft sind, ggf. mit Aluminium beschichtete SiO₂-Materiatien und Papier. Diese Substrate können einer Temperaturvorbehandlung unterzogen werden, oberflächlich aufgerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Siliciumbzw. Siliciumdioxid-Substraten kommen hierfür Haftvermittler vom Aminosilan-Typ, wie z. B. 3-Aminopropyltriethoxysilan oder Hexamethyl-disilazan, in Frage.

Beispiele für Träger, die zur Herstellung von photomechanischen Aufzeichnungsschichten, wie Druckformen für den Hochdruck, Flachdruck und Siebdruck sowie von Reliefkopien, Verwendung finden können, sind Aluminiumplatten, ggf. anodisch oxidiert, gekörnt und/oder silikatisiert, Zinkplatten und Stahlplatten, die ggf. verchromt wurden, sowie Kunststoffolien oder Papier.

Das erfindungsgemäße Aufzeichnungsmaterial wird bildmäßig belichtet. Quellen aktinischer Strahlung sind: Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- oder/und Quecksilberdampflampen. Darüber hinaus lassen sich auch Laserlichtquellen verwenden, z. B. Excimerlaser, insbesondere KrF- oder ArF-Laser, die bei 249 bzw. 193 nm emittieren. Die Strahlungsquellen müssen in den genannten Wellenlängenbereichen eine ausreichende Emission aufweisen.

Die Schichtstärke variiert in Abhängigkeit von ihrem Einsatzgebiet. Sie beträgt zwischen 0,1 und 100 µm, insbesondere zwischen 1 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann ggf. durch Erhitzen der Schicht auf Temperaturen bis zu 150 ^{o}C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien ausgewiesene Materialien Anwendung finden. Anschließend wird die Schicht bildmäßig bestrahlt. Danach wird in der strahlungsempfindlichen Schicht durch Entwicklung ein Bildmuster freigelegt, indem die Schicht mit einer Entwicklerlösung behandelt wird, die die nichtbestrahlten Bereiche des Materials löst bzw. entfernt.

Als Entwickler werden Lösungen von Reagenzien wie z.B. Silikaten, Metasilikaten, Hydroxiden, Hydrogen- bzw. Dihydrogenphosphaten, Carbonaten bzw. Hydrogencarbonaten, von Alkali und/oder Erdalkali, insbesondere von Ammoniumionen, aber auch Ammoniak und dergleichen verwendet. Metallionenfreie Entwickler werden in den EP-A 0 023 758, 0 062 733 und 0 097 282 sowie den US-A 4,141,733, 4,628,023 und 4,729,941, beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden insbesondere verwendet. Den Entwicklern können ggf. geringere Mengen eines Netzmittels zugesetzt sein, um die Ablösung der nichtbelichteten Stellen im Entwickler zu erleichtern.

Die entwickelten Resiststrukturen sind bereits erstaunlich thermostabil; sie können jedoch ggf. nachgehärtet werden. Dies geschieht im allgemeinen dadurch, daß man die Resiststruktur auf einer hot-plate bis zu einer Temperatur unter der Fließtemperatur erhitzt und anschließend mit UV-Licht einer Xenon-Quecksilber-Dampflampe (Bereich von 200 bis 250 nm) ganzflächig belichtet. Durch diese Nachhärtung werden die Resiststrukturen zusätzlich vernetzt, so daß die Strukturen eine Fließbeständigkeit im allgemeinen bis zu Temperaturen von bis zu 300 ^{o}C aufweisen. Die Nachhärtung kann auch ohne Temperaturerhöhung unter Einstrahlung von energiereichem UV-Licht oder nur durch einen Temperaturschritt erfolgen.

Bevorzugte Anwendung findet das erfindungsgemäße strahlungsempfindliche Gemisch in lithographischen Prozessen zur Herstellung integrierter Schaltungen oder von diskreten elektrischen Bausteinen. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die nachstehend beschriebenen Beispiele stellen lediglich eine Auswahl der Erfindung dar. Diese soll daher nicht auf die Beispiele begrenzt sein.

Die Beispiele 1 bis 13 belegen die Eignung des erfindungsgemäßen Gemisches für Aufzeichnungsmaterialien in der Mikrolithographie unter Verwendung von Strahlung unterschiedlichster Energie. Anhand der Vergleichsbeispiele 14 und 15 wird die Überlegenheit der erfindungsgemäßen Gemische gegenüber dem Stand der Technik belegt. Die Beispiele 16 und 17 dokumentieren die Anwendbarkeit des Gemisches in gedruckten Schaltungen und Flachdruckplatten.

### Beispiel 1:

Es wurde eine Beschichtungslösung hergestellt aus

| | |
|---|---|
| 7,5 GT | eines Kresol-Formaldehyd-Novolaks mit einem Erweichungsbereich von 105 bis 120°C, |
| 2,0 GT | eines Kresol-Formaldehyd-Resols (Bakelite R5363) und |
| 0,7 GT | Phenylsulfonyl-4-methoxybenzoyl-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.000 Umdrehungen pro Minute aufgeschleudert. Nach der Trocknung auf 100°C für 1 min auf der hot plate wurde eine Schichtdicke von 1,05 µm erhalten.

Das Aufzeichnungsmaterial wurde bildmäßig unter einer Vorlage mit der UV-Strahlung einer Xenon-Quecksilberdampflampe bei 365 nm mit einer Energie von 60 mJ/cm² belichtet. Danach wurde der Wafer 5 min bei Raumtemperatur gelagert und dann auf einer Hot plate 2 min bei 100°C nachgetempert.

Entwickelt wurde das Aufzeichnungsmaterial mit einem 0,3 n alkalischen Entwickler folgender Zusammensetzung:

| | |
|---|---|
| 5,3 GT | Natriummetasilikat x 9 H₂O, |
| 3,4 GT | Trinatriumphosphat x 12 H₂O, |
| 0,3 GT | Natriumdihydrogenphosphat und |
| 191 GT | vollentsalztes Wasser. |

Nach einer Entwicklungsdauer von 60 s erhielt man ein fehlerfreies negatives Abbild der Maske mit steilen Resistflanken, wobei auch Strukturen < 1 µm detailgetreu aufgelöst waren. Eine Untersuchung der Flanken der Resistprofile mittels Rasterelektronenmikroskopie belegte, daß diese praktisch senkrecht zur Substratoberfläche ausgerichtet waren.

### Beispiel 2:

Es wurde eine Beschichtungslösung hergestellt aus

| | |
|---|---|
| 7,5 GT | eines Copolymeren aus Styrol/p-Hydroxystyrol (20/80) mit einem mittleren Molekulargewicht von 32.000, |
| 2,0 GT | Hexamethoxymethylmelamin und |
| 0,7 GT | Phenylsulfonyl-toluoyl-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.000 Umdrehungen pro Minute aufgeschleudert. Nach der Trocknung auf 100°C für 1 min auf der hot plate wurde eine Schichtdicke von 1,12 µm erhalten.

Das Aufzeichnungsmaterial wurde bildmäßig unter einer Vorlage mit der UV-Strahlung einer Xenon-Quecksilberdampflampe bei 260 nm mit einer Energie von 45 mJ/cm² belichtet, nach kurzer Lagerung 2 min auf 105°C nacherwärmt und anschließend mit dem in Beispiel 1 beschriebenen Entwickler verarbeitet.

Nach einer Entwicklungsdauer von 60 s erhielt man ein fehlerfreies Abbild der Maske mit hoher Flankenstabilität, wobei auch hier Strukturen < 1 µm detailgetreu aufgelöst waren.

### Beispiel 3:

Ein entsprechend Beispiel 1 hergestellter Wafer wurde unter einer Vorlage mit UV-Licht einer Wellenlänge von 405 nm mit einer Energie von 85 mJ/cm² bestrahlt. Nach Temperung und der Entwicklung wurde ein originalgetreues negatives Abbild der Vorlage erhalten.

### Beispiel 4:

Der Versuch von Beispiel 3 wurde wiederholt, jedoch wurde UV-Licht einer Wellenlänge von 436 nm verwendet. Um ein negatives, kantenscharfes Abbild der Vorlage zu erhalten mußte eine Belichtungsenergie von 160 mJ/cm² eingesetzt werden.

### Beispiel 5:

Es wurde eine Beschichtungslösung hergestellt aus

| | |
|---|---|
| 7,5 GT | eines 1:1 Copolymeren aus Styrol und Maleimid mit einem Erweichungsbereich von 165 bis 180°C, |
| 2,0 GT | 4,4'-Bismethoxymethyldiphenylether, und |
| 0,7 GT | Phenylsulfonyl-(4-chlor-benzoyl)-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.700 Umdrehungen pro Minute aufgeschleudert. Nach der Trocknung auf 100°C für 1 min auf der hot plate wurde eine Schichtdicke von 0.88 µm erhalten.

Das Aufzeichnungsmaterial wurde bildmäßig unter einer Vorlage mit der UV-Strahlung einer Xenon-Quecksilberdampflampe bei 260 nm mit einer Energie von 95 mJ/cm² belichtet. Das Material wurde 5 min bei Raumtemperatur gelagert und dann zur Vervollständigung der Reaktion 2 min auf 115°C erhitzt.

Entwickelt wurde das Aufzeichnungsmaterial mit einer 0,02 n wäßrigen Lösung von Tetramethylammoniumhydroxyd, wobei die nichtbelichteten Bereiche innerhalb von 60 s rückstandsfrei abgelöst wurden.

Ein weiteres Mal wurde ein fehlerfreies negatives Abbild der Maske mit steilen Resistflanken erhalten. Der Abtrag in den belichteten Bereichen war < 10 nm; auch Strukturen < 1 µm waren detailgetreu aufgelöst.

### Beispiel 6:

Es wurde eine Beschichtungslösung hergestellt aus

| | |
|---|---|
| 7,5 GT | eines 1:1 Copolymeren aus Styrol und Maleimid mit einem Erweichungsbereich von 165 bis 180°C, |
| 2,0 GT | Hexa-acetoxymethylmelamin, |
| 0,8 GT | 2-Naphthoyl-phenylsulfonyl-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.500 Umdrehungen pro Minute aufgeschleudert. Nach der Trocknung auf 100°C für 1 min auf der hot plate wurde eine Schichtdicke von 1,00 µm erhalten.

Das Aufzeichnungsmaterial wurde bildmäßig unter einer Vorlage mit der UV-Strahlung einer Xenon-Quecksilberdampflampe bei 260 nm mit einer Energie von 85 mJ/cm² belichtet und wie im vorgehend beschriebenen Beispiel beschrieben getempert.

Entwickelt wurde das Aufzeichnungsmaterial mit einer 0,02 n wäßrigen Lösung von Tetramethylammoniumhydroxyd, wobei die unbelichteten Bereiche innerhalb von 60 s rückstandsfrei abgelöst wurden und ein detailgetreues Abbild der Vorlage erhältlich war. Die Kantensteilheit des Bildes war ausgezeichnet.

### Beispiel 7:

Es wurde eine Beschichtungslösung hergestellt aus

| | |
|---|---|
| 7,5 GT | eines Kresol-Formaldehyd-Novolaks mit einem Erweichungsbereich von 105 bis 120°C, |
| 2,0 GT | eines Kresol-Formaldehyd-Resols (Bakelite R5363), und |
| 0,7 GT | Bis-(4-chlorphenylsulfonyl)-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.000 Umdrehungen pro Minute aufgeschleudert. Nach der Trocknung auf 100°C für 1 min auf der hot plate wurde eine Schichtdicke von 1,04 µm erhalten.

Das Aufzeichnungsmaterial wurde bildmäßig unter einer Vorlage mit der UV-Strahlung einer Xenon-Quecksilberdampflampe bei 365 nm mit einer Energie von 55 mJ/cm² belichtet, anschließend 5 min bei Raumtemperatur gelagert und dann für 90 s auf 130°C erwärmt.

Entwickelt wurde das Aufzeichnungsmaterial mit dem in Beispiel 1 beschriebenen Entwickler.

Nach einer Entwicklungsdauer von 60 s erhielt man wiederum ein negatives, fehlerfreies Abbild der Maske mit steilen, praktisch vertikalen Resistflanken, wobei auch Strukturen < 0,6 µm detailgetreu aufgelöst waren.

### Beispiel 8:

Es wurde eine Beschichtungslösung hergestellt aus

| | |
|---|---|
| 7,5 GT | eines Copolymeren aus Styrol/p-Hydroxystyrol (20/80) mit einem mittleren Molekulargewicht von 32.000, |
| 2,0 GT | Hexamethoxymethylmelamin und |
| 0,7 GT | Bis-(4-bromphenylsulfonyl)-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.200 Umdrehungen pro Minute aufgeschleudert. Nach der Trocknung auf 100°C für 1 min auf der hot plate wurde eine Schichtdicke von 1,3 µm erhalten.

Das Aufzeichnungsmaterial wurde bildmäßig unter einer Vorlage mit der UV-Strahlung einer Xenon-Quecksilberdampflampe bei 260 nm mit einer Energie von 75 mJ/cm² belichtet, wie im vorstehend beschriebenen Beispiel gelagert und getempert und anschließend mit dem in Beispiel 1 beschriebenen Entwickler verarbeitet.

Nach einer Entwicklungsdauer von 60 s erhielt man ein negatives fehlerfreies Abbild der Maske mit hoher Flankenstabilität, wobei auch hier Strukturen < 0.6 µm detailgetreu aufgelöst waren.

### Beispiel 9:

Ein entsprechend Beispiel 8 hergestellter Wafer wurde unter einer Vorlage mit UV-Licht eines KrF-Excimer-Lasers mit einer Wellenlänge von 248 nm mit einer Energie von 50 mJ/cm² bestrahlt. Der Wafer wurde dann 15 min bei Raumtemperatur gelagert, und für etwa 45 Sekunden auf 140°C auf der hot plate erwärmt. Nach der Entwicklung wurde ähnlich wie in Beispiel 8 ein originalgetreues negatives Abbild der Vorlage erhalten, in dem auch Strukturen im Submikronbereich detailgetreu wiedergegeben wurden.

### Beispiel 10:

Der Versuch von Beispiel 7 wurde wiederholt, jedoch wurde UV-Licht einer Wellenlänge von 436 nm verwendet. Um ein negatives kantenscharfes Abbild der Vorlage zu erhalten mußte eine Belichtungsenergie von 145 mJ/cm² eingesetzt werden.

### Beispiel 11:

Es wurde eine Beschichtungslösung hergestellt aus

| | |
|---|---|
| 7,5 GT | eines 1:1 Copolymeren aus Styrol und Maleimid mit einem Erweichungsbereich von 165 bis 180°C, |
| 2,0 GT | Hexa-acetoxymethylmelamin, und |
| 0,7 GT | Bis-(4-t-butylphenylsulfonyl)-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.300 Umdrehungen pro Minute aufgeschleudert. Nach der Trocknung auf 100°C für 1 min auf der hot plate wurde eine Schichtdicke von 1,1 µm erhalten.

Das Aufzeichnungsmaterial wurde bildmäßig unter einer Vorlage mit der UV-Strahlung einer Xenon-Quecksilberdampflampe bei 260 nm mit einer Energie von 76 mJ/cm² belichtet, 5 min bei Raumtemperatur gelagert und dann für 2 min auf 120°C erwärmt.

Entwickelt wurde das Aufzeichnungsmaterial mit einer 0,02 n wäßrigen Lösung von Tetramethylammoniumhydroxyd, wobei die unbelichteten Bereiche innerhalb von 60 s rückstandsfrei abgelöst wurden während die belichteten Bereiche praktisch keinerlei Abtrag zeigten.

Ein weiteres Mal wurde ein fehlerfreies negatives Abbild der Maske mit zufriedenstellend steilen Resistflanken erhalten. Der Hellabtrag war nach Messung mit einem Schichtdickenmeßgerät der Fa. Rudolph < 8 nm; auch Strukturen < 0.55 µm waren detailgetreu aufgelöst.

### Beispiel 12:

Es wurde eine Beschichtungslösung hergestellt aus

| | |
|---|---|
| 7,5 GT | eines 1:1 Copolymeren aus Styrol und Maleimid mit einem Erweichungsbereich von 165 bis 180°C, |
| 2,0 GT | 4,4'-Bis-methoxymethyldiphenylsulfon, |
| 0,8 GT | Bis-(t-butylphenylsulfonyl)-diazomethan in |
| 42 GT | Propylenglykolmonomethyletheracetat. |

Die Lösung wurde durch einen Filter mit einem Porendurchmesser von 0,2 µm filtriert und auf einen mit einem Haftvermittler (Hexamethyldisilazan) behandelten Wafer bei 3.500 Umdrehungen pro Minute aufgeschleudert. Nach der Trocknung auf 100°C für 1 min auf der hot plate wurde eine Schichtdicke von 1,06 µm erhalten.

Das Aufzeichnungsmaterial wurde bildmäßig unter einer Vorlage mit der UV-Strahlung einer Xenon-Quecksilberdampflampe bei 260 nm mit einer Energie von 92 mJ/cm² belichtet und enstsprechend Beispiel 1 nachgetempert.

Entwickelt wurde das Aufzeichnungsmaterial mit einer 0,02 n wäßrigen Lösung von Tetramethylammoniumhydroxyd, wobei die unbelichteten Bereiche innerhalb von 60 s rückstandsfrei abgelöst wurden und ein detailgetreues Abbild der Vorlage erhältlich war. Die Kantensteilheit des Bildes betrug mehr als 88°.

### Beispiel 13:

Das Aufzeichnungsmaterial aus Beispiel 11 wurde mit Synchrotronstrahlung (BESSY, Berlin, 754 MeV) durch eine Gold-auf-Silizium-Maske mit einer Dosis von 150 mJ/cm² bestrahlt. Den experimentellen Aufbau findet man bei A. Heuberger, Microelectr. Eng., 3, 535 (1985). Das Material wurde etwa 10 min bei Raumtemperatur gelagert und dann 2 min auf 110°C erwärmt. Nach Entwicklung mit dem in Beispiel 11 beschriebenen Entwickler und einer Entwicklungsdauer von 70 s erhielt man ein fehlerfreies negatives Bild der Maske bis herab zu Strukturen < 0.4 µm. Die Resistflanken waren praktisch senkrecht zur planaren Substratoberfläche.

### Beispiele 14 und 15 (Vergleichsbeispiele):

Die Resistformulierung des Beispiels 11 wurde derart abgeändert, daß die dort verwendete säurebildende Verbindung durch die gleiche Menge von Triphenylsulfonium-hexafluorophosphat (Beispiel 14) oder 2-Nitrobenzyltosylat (Beispiel 15)

ersetzt wurde. Nach einer Belichtung mit Strahlung einer Wellenlänge von 260 nm und einer Energie von 95 bzw. 115 mJ/cm² sowie dort beschriebener Temperung und Entwicklung mit einem Entwickler der in Beispiel 11 angegebenen Zusammensetzung erhielt man Strukturen, die keine praxisgerechte Bilddifferenzierung zeigten.

Bei Verwendung des Onium-Salzes (Beispiel 14) wurden auch in den unbelichteten Bereichen Lackreste beobachtet, d.h. Resistreste hafteten in den unbelichteten Bereichen am Substrat an, während bei Verwendung des Tosylesters (Beispiel 15) unterschnittene Resistprofile sichtbar waren, die auch bei verstärkter Belichtung nur auf Kosten der Wiedergabegenauigkeit beseitigt werden konnten. In beiden Fällen waren somit keine akzeptablen Strukturierungen erhältlich.

### Beispiel 16:

Für die Herstellung einer Offsetdruckplatte wurde eine mechanisch aufgerauhte und vorbehandelte Aluminiumfolie mit einer Beschichtungslösung nachstehender Zusammensetzung schleuderbeschichtet:

| | |
|---|---|
| 7,5 GT | eines Kresol-Formaldehyd-Novolaks mit einem Erweichungsbereich von 105 bis 120°C, |
| 2,3 GT | eines Kresol/Formaldehyd Resols (Bakelite R 5363), |
| 0,5 GT | Bis-(4-chlorphenylsulfonyl)-diazomethan, |
| 0,05 GT | Kristallviolettbase in |
| 90 GT | Propylenglykolmonomethyletheracetat. |

Nach dem Trocknen der Schicht (Schichtgewicht ca. 2,5 g/m²) wurde unter einer negativen Testvorlage 30 s belichtet und die Platte nach 10 minütiger Lagerung für 2 min in einem Umluftofen mit einer Temperatur von 140°C erwärmt. Es wurde mit einem Entwickler folgender Zusammensetzung entwickelt:

| | |
|---|---|
| 0,5 GT | Natriumhydroxyd, |
| 0,8 GT | Natriummetasilikat x 9 H₂O, |
| 1,0 GT | 2-n-Butoxy-ethanol in |
| 97,7 GT | vollentsalztem Wasser. |

Bei der Entwicklung wurde eine detailgetreue inverse Wiedergabe der Vorlage sichtbar. Nach Abspülen mit Wasser wurde die Platte durch Überwischen mit 1%iger Phosphorsäure druckfertig gemacht. Nach dem Einspannen in eine Druckmaschine wurden 175.000 einwandfreie Abdrucke der Vorlage erhalten.

### Beispiel 17:

Die Lösung eines Ätz- und Galvanonegativtrockenresists wurde durch Bereitung nachstehender Zusammensetzung hergestellt:

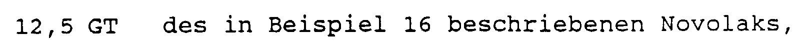

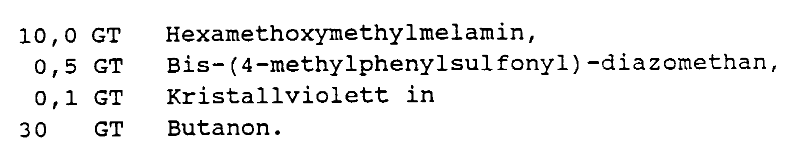

Eine für diesen Zweck übliche Polyethylenterephthalatfolie von 25 µm Dicke wurde mit dieser Lösung beschichtet, so daß sich eine Trockenschichtdicke von 18 µm ergab. Die Oberfläche des trockenen Resistfilms wurde mit einer weiteren Polyethylenterephthalatfolie kaschiert. Der Trockenfilm wurde nach Abziehen der Deckfolie unter Druck und Wärme auf ein Messingblech auflaminiert. Nach Abkühlen und Abziehen der Trägerfolie wurde das Blech durch eine Vorlage hindurch belichtet, wobei ein guter Bildkontrast sichtbar wurde. Das Material wurde 10 min gelagert und dann für 4 min auf 95°C erwärmt. Die unbelichteten Stellen wurden mit einem Entwickler der in Beispiel 16 angegebenen Zusammensetzung sprühentwickelt. Das Blech wurde anschließend mit handelsüblicher Ferrichlorid-Lösung geätzt, bis die zu glatten Flanken durchgeätzt waren. Die erhaltenen Formteile können vor dem Vereinzeln noch weiter bearbeitet werden.

## Patentansprüche

1. Negativ arbeitendes strahlungsempfindliches Gemisch, im wesentlichen enthaltend
a) eine Verbindung, die unter Bestrahlung eine Säure bildet,
b) eine Verbindung mit mindestens zwei durch Säure vernetzbaren reaktiven Gruppen, und
c) ein in Wasser unlösliches, in wäßrig-alkalischen Lösungen lösliches oder zumindest quellbares Bindemittel,
dadurch gekennzeichnet, daß die Verbindung (a) eine verbindung der allgemeinen Formel I 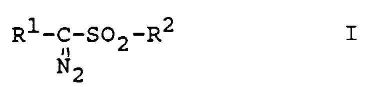 ist, in welchem R₁ für einen Rest
R²-SO₂- oder R³-C(O)-
und R² und R³ unabhängig voneinander einen ggf. substituierten Alkyl-, Cycloalkyl-, Aryl- oder Heteroarylrest bedeuten.

2. Negativ arbeitendes strahlungsempfindliches Gemisch nach Anspruch 1, dadurch gekennzeichnet, daß die Reste R² und R³ der Verbindung der allgemeinen Formel I einen ggf. substituierten Alkyl-, oder Cycloalkylrest, einen ggf. substituierten Arylrest oder einen Heteroarylrest bedeuten.

3. Negativ arbeitendes strahlungsempfindliches Gemisch nach Anspruch 1 oder 2, dadurch gekennzeichnet, daß mindestens einer der Reste R² und R³ der Verbindung der allgemeinen Formel I einen ggf. substituierten Alkylrest mit 1 bis 6 Kohlenstoffatomen oder einen ggf. substituierten Arylrest bedeutet.

4. Negativ arbeitendes strahlungsempfindliches Gemisch nach den Ansprüchen 1 bis 3, dadurch gekennzeichnet, daß mindestens einer der Reste R² und R³ der Verbindung der allgemeinen Formel I einen substituierten Arylrest bedeutet.

5. Negativ arbeitendes strahlungsempfindliches Gemisch nach einem der Ansprüche 1 bis 4, dadurch gekennzeichnet, daß die Substituenten der aromatischen Reste R² und R³ aus der Gruppe der Alkyl-, Alkoxy-, Alkoxyalkyl-, Cyanoreste oder Halogenatome ausgewählt sind.

6. Negativ arbeitendes strahlungsempfindliches Gemisch, nach den Ansprüchen 1 bis 5, dadurch gekennzeichnet, daß die Konzentration der säurebildenden Verbindung der allgemeinen Formel I 0.5 bis 25 Gew.-% beträgt.

7. Negativ arbeitendes strahlungsempfindliches Gemisch nach den Ansprüchen 1 bis 6, dadurch gekennzeichnet, daß das Bindemittel im Wellenlängenbereich der Einstrahlung eine Extinktion von < 0.5 µm⁻¹ aufweist.

8. Negativ arbeitendes strahlungsempfindliches Gemisch nach den Ansprüchen 1 bis 7, dadurch gekennzeichnet, daß es als Bindemittel bis zu 30 Gew.-%, insbesondere bis zu 20 Gew.-%, eines Novolak-Kondensationsharzes enthält.

9. Negativ arbeitendes strahlungsempfindliches Gemisch nach den Ansprüchen 7 und 8, dadurch gekennzeichnet, daß das Bindemittel phenolische Hydroxylgruppen enthält.

10. Negativ arbeitendes strahlungsempfindliches Gemisch nach den Ansprüchen 7 bis 9, dadurch gekennzeichnet, daß das Bindemittel in einer Konzentration von 50 bis 96 Gew.-%, insbesondere 60 bis 94 Gew.-%, im strahlungsempfindlichen Gemisch enthalten ist.

11. Negativ arbeitendes strahlungsempfindliches Gemisch nach den Ansprüchen 7 bis 10, dadurch gekennzeichnet, daß das Bindemittel oberhalb 240 nm eine Extinktion von < 0.3 µm-1 aufweist.

12. Negativ arbeitendes strahlungsempfindliches Gemisch nach den Ansprüchen 1 bis 11, dadurch gekennzeichnet, das die vernetzbare Verbindung ein Resol ist.

13. Negativ arbeitendes strahlungsempfindliches Gemisch nach den Ansprüchen 1 bis 12, dadurch gekennzeichnet, das die vernetzbare Verbindung ein alkoxymethyl- oder glycidylsubstituierter Aromat ist.

14. Negativ arbeitendes strahlungsempfindliches Gemisch nach den Ansprüchen 1 bis 13, dadurch gekennzeichnet, das die vernetzbare Verbindung ein Melamin/- oder Harnstoff/Formaldehyd-Kondensat ist.

15. Negativ arbeitendes strahlungsempfindliches Gemisch nach Anspruch 1, dadurch gekennzeichnet, daß die Verbindung der allgemeinen Formel I von allen Resistbestandteilen bei 248 nm die höchste molare Absorption aufweist.

16. Negativ arbeitendes strahlungsempfindliches Aufzeichungsmaterial, im wesentlichen bestehend aus einem Träger und einer strahlungsempfindlichen Schicht, dadurch gekennzeichnet, daß die Schicht aus einem strahlungshärtbaren Gemisch gemäß Ansprüchen 1 bis 15 besteht.

17. Verfahren zur Herstellung eines strahlungsempfindlichen Aufzeichnungsmaterials, dadurch gekennzeichnet, daß ein negativ arbeitendes strahlungsempfindliches Gemisch gemäß den Ansprüchen 1 bis 16 auf das Substrat aufgetragen und das Lösemittel durch Verdampfen entfernt wird.

18. Verfahren nach Anspruch 17, dadurch gekennzeichnet, daß das Aufzeichnungsmaterial bildmäßig belichtet, erwärmt und anschließend entwickelt wird, wobei die nichtbelichteten Bereiche des Materials gelöst bzw. entfernt werden.

19. Verfahren nach den Ansprüchen 17 und 18, dadurch gekennzeichnet, daß als Strahlung UV-Licht mit einer Wellenlänge von 190 bis 450 nm verwendet wird.

20. Verfahren nach den Ansprüchen 17 bis 19, dadurch gekennzeichnet, daß als Strahlung UV-Licht mit einer Wellenlänge von 200 bis 400 nm verwendet wird.

21. Verfahren nach den Ansprüchen 17 bis 20, dadurch gekennzeichnet, daß die entwickelte Schicht nachgehärtet wird.

## Claims

1. A negative-working radiation-sensitive mixture containing essentially
a) a compound which forms an acid under irradiation,
b) a compound containing at least two reactive groups which can be crosslinked by an acid and
c) a water-insoluble binder which is soluble or at least swellable in aqueous-alkaline solutions,
in which the compound (a) is a compound of the formula I 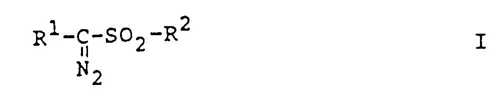 in which R₁ is a radical
R²-SO₂- or R³-C(O)-
and R² and R³ independently of one another are an optionally substituted alkyl, cycloalkyl, aryl or heteroaryl radical.

2. A negative-working radiation-sensitive mixture as claimed in claim 1, in which the radicals R² and R³ of the compound of the formula I are an optionally substituted alkyl or cycloalkyl radical, an optionally substituted aryl radical or a heteroaryl radical.

3. A negative-working radiation-sensitive mixture as claimed in either of claims 1 and 2, in which at least one of the radicals R² and R³ of the compound of the formula I is an optionally substituted alkyl radical having 1 to 6 carbon atoms or an optionally substituted aryl radical.

4. A negative-working radiation-sensitive mixture as claimed in any one of claims 1 to 3, in which at least one of the radicals R² and R³ of the compound of the formula I is a substituted aryl radical.

5. A negative-working radiation-sensitive mixture as claimed in any one of claims 1 to 4, in which the substituents of the aromatic radicals R² and R³ are chosen from the group comprising alkyl, alkoxy, alkoxyalkyl and cyano radicals and halogen atoms.

6. A negative-working radiation-sensitive mixture as claimed in any one of claims 1 to 5, in which the concentration of the acid-forming compound of the formula I is 0.5 to 25% by weight.

7. A negative-working radiation-sensitive mixture as claimed in any one of claims 1 to 6, in which the binder has an extinction of less than 0.5 µm⁻¹ in the wavelength range of the incident radiation.

8. A negative-working radiation-sensitive mixture as claimed in any one of claims 1 to 7, which contains, as the binder, up to 30% by weight, in particular up to 20% by weight, of a novolak condensation resin.

9. A negative-working radiation-sensitive mixture as claimed in either of claims 7 and 8, in which the binder contains phenolic hydroxyl groups.

10. A negative-working radiation-sensitive mixture as claimed in any one of claims 7 to 9, in which the binder is contained in the radiation-sensitive mixture in a concentration of 50 to 96% by weight, in particular 60 to 94% by weight.

11. A negative-working radiation-sensitive mixture as claimed in any one of claims 7 to 10, in which the binder has an extinction of < 0.3 µm⁻¹ above 240 nm.

12. A negative-working radiation-sensitive mixture as claimed in any one of claims 1 to 11, in which the crosslinkable compound is a resol.

13. A negative-working radiation-sensitive mixture as claimed in any one of claims 1 to 12, in which the crosslinkable compound is an alkoxymethyl- or glycidylsubstituted aromatic.

14. A negative-working radiation-sensitive mixture as claimed in any one of claims 1 to 13, in which the crosslinkable compound is a melamine/ or urea/formaldehyde condensate.

15. A negative-working radiation-sensitive mixture as claimed in claim 1, in which the compound of the formula I has the highest molar absorption of all the resist constituents at 248 nm.

16. A negative-working radiation-sensitive recording material essentially consisting of a support and a radiation-sensitive layer, in which the Layer consists of a mixture as claimed in any one of claims 1 to 15 which can be hardened by radiation.

17. A process for the production of a radiation-sensitive recording material, which comprises applying a negative-working radiation-sensitive mixture as claimed in any one of claims 1 to 16 to the substrate and removing the solvent by evaporation.

18. The process as claimed in claim 17, wherein the recording material is exposed image-wise, heated and then developed, the non-exposed areas of the material being dissolved or removed.

19. The process as claimed in either of claims 17 and 18, wherein UV light of a wavelength of 190 to 450 nm is used as the radiation.

20. The process as claimed in any one of claims 17 to 19, wherein UV light of a wavelength of 200 to 400 nm is used as the radiation.

21. The process as claimed in any one of claims 17 to 20, wherein the developed layer is post-hardened.

## Revendications

1. Composition sensible aux rayonnements travaillant en négatif contenant essentiellement
a) un composé qui forme un acide par insolation,
b) un composé avec au moins deux groupes réactifs réticulables par un acide, et
c) un liant insoluble dans l'eau, soluble ou au moins capable de gonfler dans des solutions aqueuses alcalines,
caractérisée en ce que, le composé (a) est un composé de Formule générale I 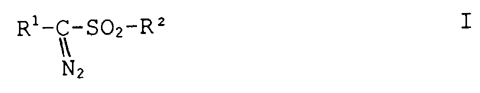 dans laquelle R¹ représente un radical
R²-SO₂- ou R³-C(O)-
et R² et R³ représentent indépendamment l'un de l'autre un radical alkyle, cycloalkyle, aryle ou hétéroaryle éventuellement substitué.

2. Composition sensible aux rayonnements travaillant en négatif selon la revendication 1, caractérisée en ce que, les radicaux R² et R³ du composé de Formule générale I représentent un radical alkyle ou cycloalkyle éventuellement substitué, un radical aryle éventuellement substitué ou un radical hétéroaryle.

3. Composition sensible aux rayonnements travaillant en négatif selon les revendications 1 ou 2, caractérisée en ce que, au moins l'un des radicaux R² et R³ du composé de Formule générale I représente un radical alkyle avec 1 à 6 atomes de carbone éventuellement substitué ou un radical aryle éventuellement substitué.

4. Composition sensible aux rayonnements travaillant en négatif selon les revendications 1 à 3, caractérisée en ce que, au moins l'un des radicaux R² et R³ du composé de Formule générale I représente un radical aryle substitué.

5. Composition sensible aux rayonnements travaillant en négatif selon l'une des revendications 1 à 4, caractérisée en ce que, les substituants des radicaux aromatiques R² et R³ sont choisis dans le groupe des radicaux alkyle, alcoxy, alcoxyalkyle, cyano ou des atomes d'halogènes.

6. Composition sensible aux rayonnements travaillant en négatif selon les revendications 1 à 5, caractérisée en ce que, la concentration du composé formant un acide de Formule générale I est de 0,5 à 25% en poids.

7. Composition sensible aux rayonnements travaillant en négatif selon les revendications 1 à 6, caractérisée en ce que, le liant présente une absorbance < 0,5 µm⁻¹ dans le domaine de longueur d'onde de l'insolation.

8. Composition sensible aux rayonnements travaillant en négatif selon les revendications 1 à 7, caractérisée en ce qu'elle contient comme liant jusqu'à 30% en poids, plus particulièrement jusqu'à 20% en poids d'une résine de condensation de type Novolaque.

9. Composition sensible aux rayonnements travaillant en négatif selon les revendications 7 et 8, caractérisée en ce que, le liant contient des groupes hydroxylés de type phénolique.

10. Composition sensible aux rayonnements travaillant en négatif selon les revendications 7 à 9, caractérisée en ce que, le liant est contenu dans la composition sensible aux rayonnements à une concentration de 50 à 96% en poids, plus particulièrement de 60 à 94% en poids.

11. Composition sensible aux rayonnements travaillant en négatif selon les revendications 7 à 10, caractérisée en ce que, le liant présente au-dessus de 240 nm une absorbance < 0,3 µm⁻¹.

12. Composition sensible aux rayonnements travaillant en négatif selon les revendications 1 à 11, caractérisée en ce que, le composé réticulable est un résol.

13. Composition sensible aux rayonnements travaillant en négatif selon les revendications 1 à 12, caractérisée en ce que, le composé réticulable est un composé aromatique substitué par un groupe alcoxyméthyle ou glycidyle.

14. Composition sensible aux rayonnements travaillant en négatif selon les revendications 1 à 13, caractérisée en ce que, le composé réticulable est un condensat de mélamine/- ou d'urée/formaldéhyde.

15. Composition sensible aux rayonnements travaillant en négatif selon la revendication 1, caractérisée en ce que, le composé de Formule générale I présente à 248 nm la plus forte absorption molaire de tous les constituants resist.

16. Matériau d'enregistrement sensible aux rayonnements travaillant en négatif constitué essentiellement d'un support et d'une couche sensible aux rayonnements, caractérisé en ce que, la couche consiste en une composition durcissable par insolation selon les revendications 1 à 15.

17. Procédé de fabrication d'un matériau d'enregistrement sensible aux rayonnements, caractérisé en ce que, l'on dépose sur le substrat une composition sensible aux rayonnements travaillant en négatif selon les revendications 1 à 16 et l'on élimine le solvant par évaporation.

18. Procédé selon la revendication 17, caractérisé en ce que, l'on insole le matériau d'enregistrement selon une image, on le chauffe et on le développe ensuite, les zones non insolées du matériau étant dissoutes et éliminées.

19. Procédé selon les revendications 17 et 18, caractérisé en ce que, l'on utilise comme rayonnement de la lumière U.V. avec une longueur d'onde de 190 à 450 nm.

20. Procédé selon les revendications 17 à 19, caractérisé en ce que, l'on utilise comme rayonnement de la lumière U.V. avec une longueur d'onde de 200 à 400 nm.

21. Procédé selon les revendications 17 à 20, caractérisé en ce que, la couche développée est durcie ultérieurement.
